# EUROPEAN PATENT SPECIFICATION

(11) **EP 4 386 869 B1**
(45) Date of publication and mention of the grant of the patent: **30.09.2026**
(21) Application number: 22874221.9
(22) Date of filing: 11.05.2022
(51) Int. Cl.: H10F 77/20, H10F 77/30

(54) **BACK CONTACT BATTERY**
RÜCKKONTAKTBATTERIE
BATTERIE À CONTACT ARRIÈRE

(30) Priority: 30.09.2021 CN 202122399281 U
(43) Date of publication of application: 19.06.2024
(73) Proprietor: Longi Solar Technology (Taizhou) Co., Ltd., Taizhou, Jiangsu 225300 (CN)
(72) Inventor: LI, Zhonglan, Taizhou, Jiangsu 225300 (CN); LU, Weiming, Taizhou, Jiangsu 225300 (CN); LI, Hua, Taizhou, Jiangsu 225300 (CN); JIN, Yupeng, Taizhou, Jiangsu 225300 (CN)
(74) Representative: Loo, Chi Ching
(86) International application number: PCT/CN2022/092270
(87) International publication number: WO 2023/050823

(56) References cited:
- CN-A- 103 460 394
- CN-A- 108 140 680
- CN-A- 111 834 470
- CN-A- 113 345 970
- CN-U- 216 488 083
- US-A1- 2014 020 756
- US-A1- 2015 179 838
- US-A1- 2015 340 531

## Description

### CROSS-REFERENCE TO RELATED APPLICATIONS

The present disclosure claims the priority of the Chinese patent application filed on September 30th, 2021 before the China National Intellectual Property Administration with the application number of 202122399281.0 and the title of "BACK CONTACT BATTERY".

### TECHNICAL FIELD

The present disclosure relates to the technology field of photovoltaics and, more particularly, to a back contact solar cell.

### BACKGROUND

A back contact solar cell refers to a solar cell that an emitter and a metal contact are located on the back of the solar cell, and there are not metal electrodes shielding the front. Comparing with the solar cell with the front being shielded, the back contact solar cell has higher short-circuit current and photoelectric conversion efficiency, and is one of the technical directions to achieve high-efficiency crystalline silicon solar cells.

Since the electrodes of the existing back contact solar cells are all on the back, problems such as electric leakage easily occur, resulting in uneven power conversion efficiency and low yield of the back contact solar cell.
US application No. 2015/179838 A1 (RIM SEUNG BUM [US] ET AL) 25 June 2015 (2015-06-25), describes methods of fabricating solar cell emitter regions with differentiated P-type and N-type regions architectures, and resulting solar cells.
US application No. 2014/020756 A1 (GOTO RYO [JP] ET AL) 23 January 2015 (2014-01-23), provides a photovoltaic device including an n-type monocrystalline silicon substrate; an IN layer layered over one surface of the n-type monocrystalline silicon substrate; and an IP layer layered over a region of one surface of the IN layer.

### SUMMARY

It is an object of the present disclosure to provide a back contact solar cell for solving the problem of electric leakage of the back contact solar cell and improving the power conversion efficiency of the back contact solar cell.

In a first aspect, a back contact solar cell is provided by the present application, as in appended claim 1.

In the case of using the technical solution stated above, there are the first doped region and the second doped region on the first surface of the substrate. The overlapping region is disposed between the first doped region and the second doped region. There is the isolating trench that is not in contact with the first doped region and the second doped region on the overlapping region. The overlapping region is divided by the isolating trench into a first overlapping region and a second overlapping region, and the first doped region and the second doped region are also separated by the isolating trench at the same time. There is the first electrode on the first doped region, and there is the second electrode on the second doped region. When the solar cell is working, the first electrode and the second electrode are respectively a positive electrode and a negative electrode. The presence of the overlapping region enables the positive electrode and the negative electrode of the solar cell to be separated, which is beneficial to ensure excellent positive and negative electrode insulation performance of the solar cell. The second doped layer is covered on the first doped layer in the overlapping region, so that a part of the surface of the first doped layer is protected. The first doped layer at the overlapping region is prevented from being damaged or introducing impurities during subsequent processing treating processes, the yield and production efficiency of the back contact solar cell are improved, while the collection of first electric carriers is ensured. In addition, the isolating trench is disposed in the overlapping region, and have a reduced width compared to the separate arrangement, thereby the width of a dead zone region in the back contact solar cell that cannot separate carriers is reduced, and the width of an effective region on the first surface is increased, thereby the power conversion efficiency of the back contact solar cell is improved.

In some possible embodiments, the second doped layer and the first doped layer on the overlapping region are penetrated by the isolating trench.

In some possible embodiments, a ratio of a width of the first overlapping region to a width of the first doped region ranges from 0.1 to 5.

In the case of using the technical solution stated above, the ratio of the width of the first overlapping region to the width of the first doped region is in the range of 0.1 to 5. The first overlapping region may better protect the first doped layer and the substrate from being damaged during subsequent processing. If the ratio of the width of the first overlapping region to the width of the first doped region is less than 0.1, the portion of the first doped region that may be protected is too small and damaged too much in subsequent processing. If the ratio of the width of the first overlapping region to the width of the first doped region is greater than 5, at this moment, the area of the first overlapping region is too large, various layers on the overlapping region may come into contact with the first electrode, and a problem that the bonding force between the first electrode and the solar cell is not strong easily occurs, so that the solar cell is easy to fall off, and the region under the electrode is uneven during subsequent printing or electroplating, thereby the yield of the solar cell is reduced. In addition, since the second doped layer on the first overlapping region is not conductive and carriers are transported to the first electrode by the first doped layer, the excessive area of the first overlapping region may also make the current transmission path of the first doped layer too long, thereby a problem of solar cell inefficiency is caused.

In some possible embodiments, a ratio of a width of the second overlapping region to a width of the second doped region is greater than 0 and less than or equal to 0.1.

In the case of using the technical solution stated above, when the ratio of the width of the second overlapping region to the width of the second doped region is greater than 0 and less than or equal to 0.1, the width of the second overlapping region is much less than the width of the second doped region, and it is possible to better collect the carriers generated from the substrate. If the ratio of the width of the second overlapping region to the width of the second doped layer is too small, the second doped layer on the second overlapping region cannot effectively protect the first doped layer and the substrate in subsequent process treatments, so that the efficiency of the solar cell is reduced. If the ratio of the width of the second overlapping region to the width of the second doped layer is too large, since the first doped layer on the second overlapping region does not play a role in conducting electricity, if the width of the second overlapping region is too large, the width of the second doped layer on the second doped region may be reduced, the carrier collection rate is reduced, and thus the power conversion efficiency of the solar cell is reduced.

In some possible embodiments, a surface of the first doped region and/or a surface of the second doped region is a polished surface.

In the case of using the technical solution stated above, both surfaces of the first doped region and the second doped region may be polished surfaces, so that light incident from the second surface and passing through the back contact solar cell is re-reflected, thereby the light is given a chance to be reused by the back contact solar cell, thereby power conversion efficiency of the back contact solar cell is improved. In addition, the polished surface has a better flatness, and the effect of subsequently forming other layers on the polished surface is better, which is beneficial to reduce the generation of interface defects, thereby the recombination of carriers due to defects is reduced. It is beneficial to improve the passivation performance of the back contact solar cell, thereby the power conversion efficiency of the back contact solar cell is improved.

In some possible embodiments, the substrate is an n-type substrate; the first doped layer is a p-type doped layer; the second doped layer is the n-type doped layer; or the substrate is the p-type substrate; the first doped layer is the n-type doped layer; and the second doped layer is the p-type doped layer. When the substrate is the n-type substrate, the first doped layer is the p-type doped layer, and the second doped layer may be a phosphorus-doped n-type doped layer. At this time, since the region where phosphorus is heavily doped has a greater solubility for metal impurities, the phosphorus present in the second doped layer may provide the first doped layer with a phosphorus gettering and passivation effect, the cell efficiency is improved.

In the case of using the technical solution stated above, the first surface passivation layer is formed at the outer sides of the first doped layer, the second doped layer and the overlapping region. The first surface passivation layer may perform surface passivation on the back contact solar cell, dangling bonds at the first doped layer, the second doped layer and the overlapping region are passivated, the carrier recombination speed of the first surface is reduced, and the power conversion efficiency is improved. The first electrode and the second electrode are electrically contacted with the first doped layer and the second doped layer via the first opening and the second opening, respectively, a local ohmic contact of a metal and a semiconductor is formed, the contact area of the metal electrode with the first doped layer and the second doped layer is reduced, the contact resistance is reduced, the recombination rate of carriers at the electrode surface is further reduced, and the open circuit voltage is increased.

The first interface passivation layer and the second interface passivation layer respectively perform interface passivation on the substrate and the first doped layer, the recombination of the carriers at the interface is reduced, and the transmission efficiency of the carriers is ensured.

In some possible embodiments, the second doped layer and the second interface passivation layer are penetrated by the isolating trench; or the second doped layer, the second interface passivation layer, the first doped layer and the first interface passivation layer are penetrated by the isolating trench.

In some possible embodiments, the back contact solar cell further includes a first protecting layer located between the first doped layer and the second interface passivation layer.

In the case of using the technical solution stated above, the first doped layer and the second doped layer of the overlapping region may be completely separated by the first protecting layer, thereby the adverse effect of the second doped layer on the first doped layer in subsequent processes is reduced. For example, in the case where there is no first protecting layer and the first doped layer is directly contacted with the second doped layer or contacted with the second doped layer via the second interface passivation layer, when at least one of the first doped layer and the second doped layer is a doped amorphous silicon layer which needs to be transformed into a doped polycrystalline silicon layer by crystallization, since the crystallization time is longer, the second interface passivation layer is thinner, and the conductivity type of the second doped layer and the conductivity type of the first doped layer are opposite. Long-time crystallization may enable the doped element in the second doped layer to enter the first doped layer, cause damage to the first doped layer, and may even cause the conductivity type of the first doped layer to change, resulting in that the solar cell cannot generate power normally. In addition, in the process of gradually forming a back contact solar cell, the formed first protective layer can protect the lower first doped layer during the subsequent patterning treatment, the surface texturing treatment and the cleaning process, so that the lower first doped layer may not be corroded or damaged.

In some possible embodiments, the second doped layer and the second interface passivation layer are penetrated by the isolating trench; or the second doped layer, the second interface passivation layer and the first protecting layer are penetrated by the isolating trench; or the second doped layer, the second interface passivation layer, the first protecting layer, the first doped layer and the first interface passivation layer are penetrated by the isolating trench.

In some possible embodiments, the first protecting layer includes at least one of a dielectric layer and a masking layer.

### BRIEF DESCRIPTION OF THE DRAWINGS

The accompanying drawings, which are included to provide a further understanding of the present disclosure and are incorporated in and constitute a part of the present disclosure. Illustrative embodiments of the present disclosure and together with the description serve to explain the present disclosure and do not constitute an undue limitation of the present disclosure. In the drawings,
FIG. 1 is a schematic diagram of a structure of a first type of a back contact solar cell according to an example of the present disclosure. This example is not part of the present invention, but is useful for understanding said invention;
FIG. 2 is a schematic diagram of a structure of a second type of a back contact solar cell according to an example of the present disclosure. This example is not part of the present invention, but is useful for understanding said invention;
FIG. 3 is a schematic diagram of a structure of a third type of a back contact solar cell according to an embodiment of the present disclosure;
FIG. 4 is a schematic diagram of a structure of a fourth type of a back contact solar cell according to an embodiment of the present disclosure;
FIG. 5 is a schematic diagram of a structure of a fifth type of a back contact solar cell according to an embodiment of the present disclosure;
FIG. 6 is a schematic diagram of a structure of a sixth type of a back contact solar cell according to an embodiment of the present disclosure;
FIG. 7 is a schematic diagram of a structure of a seventh type of a back contact solar cell according to an embodiment of the present disclosure;
FIG. 8 is a schematic diagram of a first surface of a back contact solar cell according to an embodiment of the present disclosure;
FIG. 9 is a partial schematic diagram of FIG. 8; and
FIG. 10 is a schematic diagram of a first surface of a back contact solar cell having continuous contact electrodes according to an embodiment of the present disclosure.

### Elements and reference numbers:

10-substrate, 101-first doped region,
102-second doped region, 103-overlapping region,
1030-isolating trench, 1031-first overlapping region,
1032-second overlapping region, 11-first doped layer,
12-second doped layer, 13-first surface passivation layer,
130-first opening, 131- second opening,
14-first interface passivation layer, 15-second interface passivation layer,
16-first protecting layer, 20-first electrode,
21-second electrode, 201-first electrode main electrode,
202- first electrode sub-gate line, 211-second electrode main electrode,
212-second electrode sub-gate line, 17-second surface passivation layer.

### DETAILED DESCRIP TION OF THE EMBODIMENTS

In order to make the technical problems to be solved, the technical solutions, and beneficial effects of the present disclosure clearer, the following further describes some embodiments of the present disclosure in detail with reference to the accompanying drawings and embodiments. It should be understood that the specific embodiments described herein are merely illustrative of the present disclosure and are not intended to limit the present disclosure.

It should be noted that when an element is called to be "fixed on" or "arranged on" another element, it may be directly arranged on another element or indirectly arranged on another element. When an element is called to be "connected" to another element, it may be directly connected to another element or indirectly connected to another element.

Moreover, the terms "first" and "second" are only used for descriptive purposes, but cannot be understood as indicating or implying relative importance, or implicitly indicating the number of indicated technical features. Therefore, the features defined with "first" and "second" can explicitly or implicitly include one or more of the features. In the description of the present disclosure, the meaning of "a plurality of" is two or more than two, unless otherwise specifically defined. The meaning of "several" is one or more, unless otherwise specifically defined.

In the description of the present disclosure, it should be understood that the orientation or position relationship indicated by such terms as "upper", "lower", "front", "rear", "left", "right", or the like, is based on the orientation or position relationship shown in the drawings, which is only used for convenience of description of the present disclosure and simplification of description instead of indicating or implying that the indicated device or element must have a specific orientation, and be constructed and operated in a specific orientation, and thus shall not be understood as a limitation to the present disclosure.

In the description of the present disclosure, it should be noted that unless expressly stipulated and defined otherwise, terms such as "installation", "connected" and "connection", or the like, should be understood broadly, for example, the connection may be fixed connection, or detachable connection or integral connection; may be mechanical connection, and may also be electrical connection; and may be direct connection, may also be indirect connection through an intermediate medium, and may also be internal communication of two elements or interaction relationship of two elements. The specific meaning of the above terms in the present disclosure may be understood in a specific case by those having ordinary skills in the art.

As a new energy alternative solution, solar cells are more and more widely used at present. The solar cell is a device that converts the light energy of the sun into electrical energy. Based on the photovoltaic principle, solar cells generate carriers, and then use the electrode to extract the carriers, which is conducive to the effective use of electrical energy.

Finger-shaped cross back contact solar cell is also known as IBC solar cell. IBC refers to the interdigitated back contact. The biggest feature of the IBC solar cell is that the emitter and the metal contact are on the back of the solar cell, and there are not effect of metal electrode shielding on the front, therefore the IBC solar cell has a higher short-circuit current Isc, and at the same time, a wider metal gate line can be allowed on the back to reduce the series resistance Rs, thus the fill factor FF is increased. This solar cell with the front being not shielded not only has a high conversion efficiency, but also looks more beautiful, and at the same time, the components of the full-back electrode are easier to be assembled. At present, the IBC solar cell is one of the technical directions to achieve high-efficiency crystalline silicon solar cells.

However, the solar cell efficiency of the current IBC solar cells is uneven and the yield is not high. In addition, since the electrodes of the IBC solar cell structure are all on the back, problems such as electric leakage and the like easily occur in the electrical structure, resulting in low power conversion efficiency of the solar cell.

In order to solve the above technical problem, a back contact solar cell is provided by embodiments of the present disclosure for solving the problem of electric leakage of the back contact solar cell and improving the power conversion efficiency of the back contact solar cell.

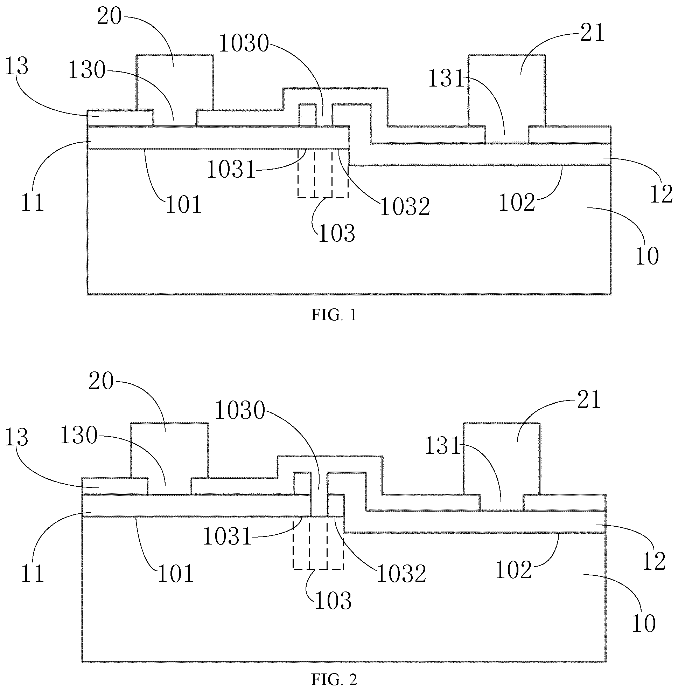

As shown in FIG. 1 to FIG. 7, a back contact solar cell provided the present disclosure includes a substrate 10, a first doped layer, a second doped layer, a first electrode and a second electrode. The substrate 10 has a first surface and a second surface opposite to each other. There are a first doped region 101, a second doped region 102 and an overlapping region 103 on the first surface, the first doped region 101 and the second doped region 102 are arranged in a staggered manner, and the overlapping region 103 is located between the first doped region 101 and the second doped region 102. The overlapping region 103 has an isolating trench 1030 for insulating contact between the first doped region 101 and the second doped region 102. The first doped layer 11 is formed on the first doped region 101 and the overlapping region 103. The second doped layer 12 formed on the first doped layer 11 on the overlapping region 103 and the second doped region 102, wherein a conductivity type of the second doped layer 12 is opposite to a conductivity type of the first doped layer 11. As shown in FIG. 1 and FIG. 2, the second doped layer 12 on the overlapping region 103 is penetrated by the isolating trench 1030. The overlapping region 103 is divided by the isolating trench 1030 into a first overlapping region 1031 and a second overlapping region 1032. The first overlapping region 1031 is close to the first doped region 101. The second overlapping region 1032 is close to the second doped region 102. The first electrode 20 is electrically contacted with the first doped layer 11. The second electrode 21 is electrically contacted with the second doped layer 12.

It can be seen from the above-mentioned structure of the back contact solar cell that there are the first doped region 101 and the second doped region 102 on the first surface of the substrate 10. The overlapping region 103 is disposed between the first doped region 101 and the second doped region 102. There is the isolating trench 1030 that is not in contact with the first doped region 101 and the second doped region 102 on the overlapping region 103. The overlapping region 103 is divided by the isolating trench 1030 into a first overlapping region 1031 and a second overlapping region 1032, and the first doped region 101 and the second doped region 102 are also enabled by the isolating trench 1030 to be separated from each other at the boundary at the same time. There is the first electrode 20 on the first doped region 101, and there is the second electrode 21 on the second doped region 102. When the solar cell is working, the first electrode 20 and the second electrode 21 are respectively a positive electrode and a negative electrode. The presence of the overlapping region 103 enables the positive electrode and the negative electrode of the solar cell to be separated, which is beneficial to ensure excellent positive and negative electrode insulation performance of the solar cell. At the same time, the design of the isolating trench 1030 eliminates the insulator design between the positive electrode and the negative electrode in the prior art, the production process flow may be reduced and the space complexity may also be reduced. Such a structure does not have the phenomenon of coexistence of the positive electrode and the negative electrode in the vertical direction, and the occurrence of electric leakage of the back contact solar cell is avoided. In addition, the reliability performance of the solar cell in the later product may be improved, and the difficulty in the production process of the back contact solar cell may be reduced. The second doped layer 12 is covered on the first doped layer 11 in the overlapping region 103, so that a part of the surface of the first doped layer 11 is protected. The first doped layer 11 at the overlapping region 103 is prevented from being damaged or introducing impurities during subsequent processing treating processes, thereby the yield and production efficiency of the back contact solar cell are improved, while the collection of first electric carriers is ensured. In addition, the isolating trench 1030 is disposed in the overlapping region 103, and have a reduced width compared to the separate arrangement, thereby the width of a dead zone region in the back contact solar cell that cannot separate carriers is reduced, and the width of an effective region on the first surface is increased, thereby the power conversion efficiency of the back contact solar cell is improved.

In some examples, as shown in FIGs. 1-7, a width of the isolating trench 1030 ranges from 10 µm to 100 µm. Too wide width of the isolating trench 1030 may cause the effective area of the back contact solar cell to be wasted and the effective carriers to be collected difficultly, thereby the solar cell performance is reduced.

Exemplarily, the width of the isolating trench 1030 may be 10 µm, 100 µm, or 70 µm.

Here, the substrate 10 is a semiconductor substrate 10. The material of the substrate 10 may be selected from a material such as silicon (Si) or germanium (Ge) or a material such as gallium arsenide (GaAs). Obviously, in terms of the conductivity type, the substrate 10 may be an intrinsic conductive substrate 10, an n-type conductive substrate 10 or a p-type conductive substrate 10. Optionally, the substrate 10 is a p-type conductive substrate 10 or an n-type conductive substrate 10. Compared with the intrinsic conductive substrate 10, the p-type conductive substrate 10 or the n-type conductive substrate 10 has a better electrical conductivity, so that the finally prepared back contact solar cell has a lower bulk resistivity, thereby the efficiency of the back contact solar cell is improved. In practical applications, the substrate 10 needs to be polished, cleaned, etc. to remove damage.

Exemplarily, the substrate 10 is an n-type silicon substrate 10. Compared with the p-type conductive substrate 10, the n-type conductive substrate 10 has advantages of high minority carrier lifetime, no optical degradation, good low-light performance, etc.

The first doped layer 11 and the second doped layer 12 are also both semiconductor doped layers. The first doped layer 11 and the second doped layer 12 may be amorphous, microcrystalline, single crystalline, nanocrystalline or polycrystalline, etc. in terms of the internal arrangement form of the substance. In terms of specific materials, the materials of the first doped layer 11 and the second doped layer 12 may be silicon (Si), germanium (Ge), silicon carbide (SiCₓ) or gallium arsenide (GaAs), etc. In terms of conductivity type, the first doped layer 11 and the second doped layer 121 may be an n-type doped layer or a p-type doped layer.

In some examples, when the substrate 10 is an n-type substrate 10, the first doped layer 11 may be a p-type doped layer and the second doped layer 12 may be an n-type doped layer. Alternatively, when the substrate 10 is a p-type substrate 10, the first doped layer 11 may be an n-type doped layer and the second doped layer 12 may be a p-type doped layer.

Exemplarily, the substrate 10 is an n-type silicon substrate 10, the first doped layer 11 is a boron-doped p-type doped layer, and the second doped layer 12 is a phosphorus-doped n-type doped layer. At this moment, since the region where phosphorus is heavily doped has a greater solubility for metal impurities, the phosphorus present in the second doped layer 12 may provide the first doped layer 11 with a phosphorus gettering and passivation effect, the solar cell efficiency is improved. When light is incident on the substrate 10, the substrate 10 generates an electron-hole pair (i.e., a carrier pair). When the electron-hole pair moves to the first doped region 101, the hole carriers in the first doped layer 11 is collected by the first doped layer 11, and the two electron carriers flow to and are collected by the second doped layer 12 of the second doped region 102, thereby photoelectric conversion is completed.

In some examples, the thickness of each of the first doped layer 11 and the second doped layer 12 is in the range of 50 nm to 200 nm.

In practical applications, when the first doped layer 11 is formed, the first doped layer 11 may be firstly coated the entire first surface on the substrate 10, and then the first doped layer 11 on the second doped region 102 is removed. When the second doped layer 12 is formed, the second doped layer 12 may be coated on the first doped layer 11 and the second doped region 102, and then the second doped layer 12 on the first doped region 101 is removed. In the process of forming the first doped layer 11 and the second doped layer 12, an in-situ doping method or an ex-situ doping method may be used, namely, a layer of the doped first doped layer 11 or the second doped layer 12 may be directly formed, or an intrinsic semiconductor layer may be formed first, and then the intrinsic semiconductor layer is doped to form the first doped layer 11 or the second doped layer 12.

In practical applications, the process of forming the first doped layer 11 and the second doped layer 12 may be a plasma chemical vapor deposition (PECVD) process, a hot filament chemical vapor deposition process, a physical vapor deposition (PVD) process, a low pressure chemical vapor deposition (LPCVD) process, or a catalytic chemical vapor deposition process, etc. The process of removing the first doped layer 11 and the second doped layer 12 may be a laser etching process, an ion milling etching process, a plasma etching process, a reactive ion etching process, an alkali etching process and an acid etching process, etc.

In some examples, the second doped layer 12 on the overlapping region 103 may be only penetrated by the isolating trench 1030 as shown in FIG. 1. Alternatively, the second doped layer 12 and the first doped layer 11 on the overlapping region 103 may be penetrated by the isolating trench 1030 as shown in FIG. 2.

As some possible embodiments, as shown in FIGs. 1-7, a ratio of a width of the first overlapping region 1031 to a width of the first doped region 101 ranges from 0.1 to 5.

Based on this, the ratio of the width of the first overlapping region 1031 to the width of the first doped region 101 is in the range of 0.1 to 5. The first overlapping region 1031 may better protect the first doped layer 11 and the substrate 10 from being damaged during subsequent processing. If the ratio of the width of the first overlapping region 1031 to the width of the first doped region 101 is less than 0.1, the portion of the first doped region 101 that may be protected is too small and damaged too much in subsequent processing. If the ratio of the width of the first overlapping region 1031 to the width of the first doped region 101 is greater than 5, at this moment, the area of the first overlapping region 1031 is too large, various layers on the overlapping region 103 may come into contact with the first electrode 20, and a problem that the bonding force between the first electrode 20 and the solar cell is not strong easily occurs, so that the solar cell is easy to fall off, and the region under the electrode is uneven during subsequent printing or electroplating, thereby the yield of the solar cell is reduced. In addition, since the second doped layer 12 on the first overlapping region 1031 is not conductive and carriers are transported to the first electrode 20 by the first doped layer 11, the excessive area of the first overlapping region 1031 may also make the current transmission path of the first doped layer 11 too long, thereby a problem of solar cell inefficiency is caused.

Exemplarily, the ratio of the width of the first overlapping region 1031 to the width of the first doped region 101 may be 3.

As some possible embodiments, as shown in FIGs. 1-7, a ratio of a width of the second overlapping region 1032 to a width of the second doped region 102 is greater than 0 and less than or equal to 0.1.

Based on this, when the ratio of the width of the second overlapping region 1032 to the width of the second doped region 102 is greater than 0 and less than or equal to 0.1, the width of the second overlapping region 1032 is much less than the width of the second doped region 102, and it is possible to better collect the carriers generated from the substrate 10. If the ratio of the width of the second overlapping region 1032 to the width of the second doped layer 12 is too small, the second doped layer 12 on the second overlapping region 1032 cannot effectively protect the first doped layer 11 and the substrate 10 in subsequent process treatments, so that the efficiency of the solar cell is reduced. If the ratio of the width of the second overlapping region 1032 to the width of the second doped layer 12 is too large, since the first doped layer 11 on the second overlapping region 1032 does not play a role in conducting electricity, if the width of the second overlapping region 1032 is too large, the width of the second doped layer 12 on the second doped region 102 may be reduced, the carrier collection rate is reduced, and thus the power conversion efficiency of the solar cell is reduced.

Exemplarily, the ratio of the width of the second overlapping region 1032 to the width of the second doped region 102 may be 0.05.

As some possible embodiments, as shown in FIGs. 1-7, the surface of the first doped region 101 and/or the surface of the second doped region 102 is a polished surface. At this moment, both surfaces of the first doped region 101 and the second doped region 102 may be polished surfaces, so that light incident from the second surface and passing through the back contact solar cell is re-reflected, thereby the light is given a chance to be reused by the back contact solar cell, thereby power conversion efficiency of the back contact solar cell is improved. In addition, the polished surface has a better flatness, and the effect of subsequently forming other layers on the polished surface is better, which is beneficial to reduce the generation of interface defects, thereby the recombination of carriers due to defects is reduced. It is beneficial to improve the passivation performance of the back contact solar cell, thereby the power conversion efficiency of the back contact solar cell is improved.

In the present invention, as shown in FIGs. 1-7, the back contact solar cell further includes a first surface passivation layer 13. The first surface passivation layer 13 is covered on the first doped layer 11, the second doped layer 12 and the overlapping region 103. The isolating trench 1030 is filled by the first surface passivation layer 13. A contact surface between the first surface passivation layer 13 and the first doped layer 11 is provided with a first opening 130. The first electrode 20 is electrically contacted with the first doped layer 11 via the first opening 130. A contact surface between the first surface passivation layer 13 and the second doped layer 12 is provided with a second opening 131. The second electrode 21 is electrically contacted with the second doped layer 12 via the second opening 131. Based on this, the first surface passivation layer 13 is formed at the outer sides of the first doped layer 11, the second doped layer 12 and the overlapping region 103. The first surface passivation layer 13 may perform surface passivation on the back contact solar cell, dangling bonds at the first doped layer 11, the second doped layer 12 and the overlapping region 103 are passivated, the carrier recombination speed of the first surface is reduced, and the power conversion efficiency is improved. The first electrode 20 and the second electrode 21 are electrically contacted with the first doped layer 11 and the second doped layer 12 via the first opening 130 and the second opening 131, respectively, a local ohmic contact of a metal and a semiconductor is formed, the contact area of the metal electrode with the first doped layer 11 and the second doped layer 12 is reduced, the contact resistance is reduced, the recombination rate of carriers at the electrode surface is further reduced, and the open circuit voltage is increased. At the same time, the first surface passivation layer 13 located in the isolating trench 1030 also serves to isolate the first doped region 101 from the second doped region 102.

In some examples, the material of the first surface passivation layer 13 may be one or more of silicon nitride, silicon oxide, silicon oxynitride, aluminum oxide, silicon carbide, and amorphous silicon.

In practical applications, the process of forming the first surface passivation layer 13 may be a plasma chemical vapor deposition (PECVD) process, a hot filament chemical vapor deposition process, a physical vapor deposition (PVD) process, a low pressure chemical vapor deposition (LPCVD) process, or a catalytic chemical vapor deposition process, etc.

In some examples, the isolating trench 1030 may be formed on the overlapping region 103 after the second doped layer 12 is patterned, followed by the formation of the first surface passivation layer 13. The step of forming the isolating trench 1030 may also be disposed after preparation of the back contact solar cell, but in this way, partial passivation of the isolating trench 1030 may be sacrificed.

In practical applications, the first electrode 20 and the second electrode 21 may be formed after forming the first surface passivation film.

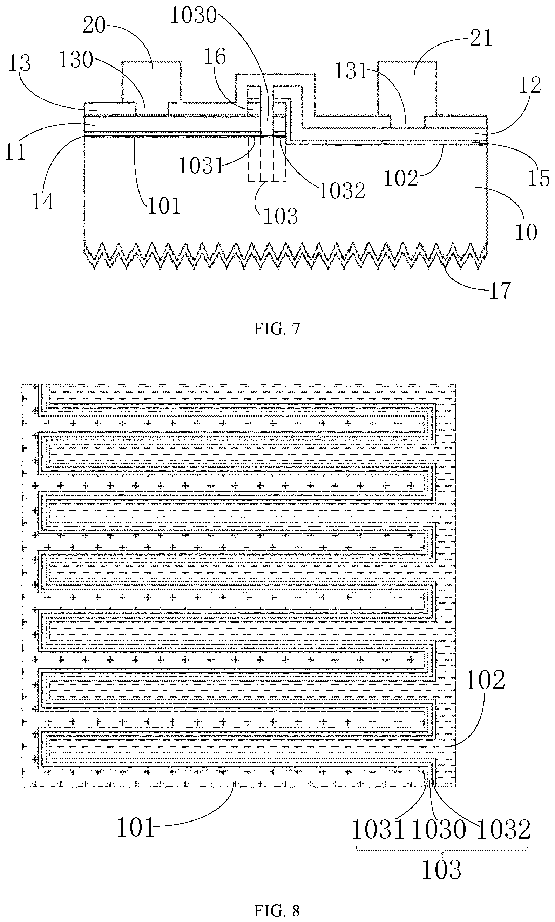

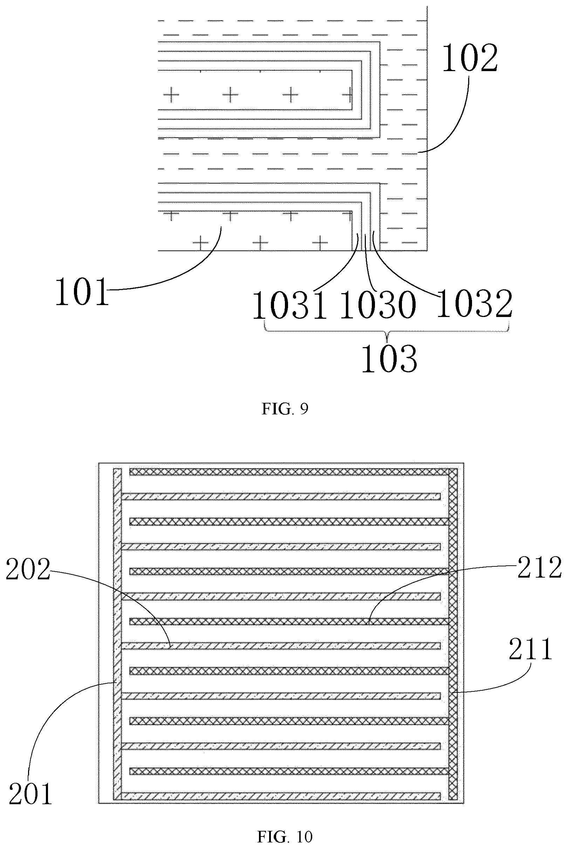

In some examples, the first electrode 20 and the second electrode 21 that are formed may be continuous contact electrodes, as shown in FIGs. 8-10. At this moment, the first electrode 20 includes a first electrode main electrode 201 and a first electrode sub-gate line 202. The second electrode 21 includes a second electrode main electrode 211 and a second electrode sub-gate line 212. The first electrode 20 and the second electrode 21 that are formed may also be local contact electrodes. At this moment, the first electrode 20 and the second electrode 21 may both include a connection electrode and a sub-gate line. Wherein, the continuous electrode is not in contact with the first doped layer 11 or the second doped layer 12. The thin gate line is in contact with the first doped layer 11 or the second doped layer 12. Alternatively, a part of the region on the thin gate line is in contact with the first doped layer 11 or the second doped layer 12, and the remaining region is not in contact. For example, local contact points on the sub-gate lines may be used to contact the first doped layer 11 or the second doped layer 12. Pads or electrode output contact points may also be disposed on the main electrode to allow power of the solar cell to be output. The thin gate line may be prepared by using different electrode slurries. For example, the fine gate line is composed of a conductive slurry I and a conductive slurry II after being subjected to the metallization heat treatment. The conductive slurry I has the property of penetrating the dielectric film. The conductive slurry II does not have the property of penetrating the dielectric film. The conductive slurry I is distributed intermittently. Part or all of the conductive slurry II is covered on the conductive slurry I, and the regions of the conductive slurry I are connected.

Exemplarily, as shown in FIGs. 8 to 10, when the first electrode 20 and the second electrode 21 are continuous contact electrodes, the width of the first electrode sub-gate line ranges from 5 µm to 50 µm, and the width of the second electrode sub-gate line ranges from 5 µm to 100 µm.

In some examples, the process of forming the first electrode 20 and the second electrode 21 may be an electroplating process, a transfer printing process (e.g., a laser transfer printing process, a thermal transfer printing process, etc.), screen printing, a process of physical vapor deposition of a metal or metal oxide electrode, etc. Obviously, various processes may also be used in combination. For example, firstly, an electrode is printed to form a power supply point, and then electricity is applied at the power supply point to form a final first electrode 20 and second electrode 21 using an electroplating process. Alternatively, the vapor deposition of a metal oxide may be used. For example, a transparent conductive oxide (TCO) may be used, and then the first electrode 20 and the second electrode 21, etc. may be formed by screen printing or transfer printing.

In practical applications, the method of forming the first electrode 20 and the second electrode 21 includes a variety of methods. For example, when the back contact solar cell has the first surface passivation layer 13, the first surface passivation layer 13 may be directly coated with a few-pass type slurry, and then subjected to heat treatment so that the electrode slurry passes through the first surface passivation layer 13 to form the electrical contact. It may also be that the first opening 130 and the second opening 131 are firstly formed on a partial region of the first doped region 101 and the second doped region 102, and then the first electrode 20 and the second electrode 21 are formed by using methods such as a printing slurry, a laser transfer printing method, electroplating, chemical plating, photo-induced plating, vacuum evaporation, and magnetron sputtering, etc. Obviously, a combination of one or more of the above methods may also be used to form the first electrode 20 and the second electrode 21, for example, a method of a seed layer using physical vapor deposition (PVD) in conjunction with printing an electrode, or a method of screen-printed electrode slurry in conjunction with electroplating, or a combination of laser transfer printing method and a screen-printed sintering method, etc.

As shown in FIGs. 8-10, when the substrate 10 is an n-type silicon substrate 10 and the first doped layer 11 is a p-type polycrystalline silicon layer, a p-type contact region is formed on the first doped region 101 under the method of opening film to form electrodes, and a first polar carrier of the first doped region 101 is collected by the first electrode 20 via the first doped layer 11 by means of the tunneling effect of the carrier. An n-type contact region is formed on the second doped region 102, and second polar carriers of the second doped region 102 are collected by the second electrode 21 by the second doped layer 12. Thereafter, the conductive slurry may be printed on the first surface passivation layer 13 and sintered to form a metallization contact, a p-type metal region on the p-type contact region is formed, and an n-type metal region on the n-type contact region is formed. Alternatively, the burn-through type slurry may be printed directly on the first surface passivation layer 13 to form corresponding P-type metal regions and N-type metal regions. The first electrode 20 and the second electrode 21 are finally formed.

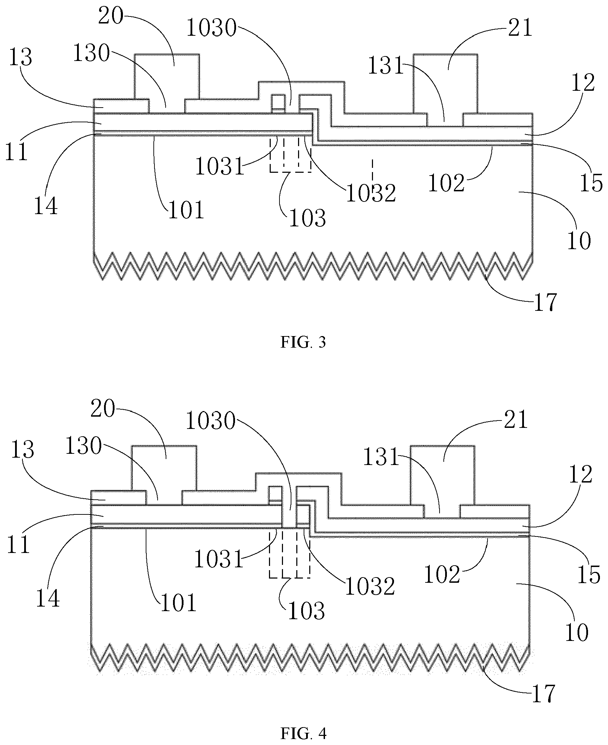

In the present invention, as shown in the embodiments illustrated in FIGs. 3-7, the back contact solar cell further includes a first interface passivation layer 14 and a second interface passivation layer 15. The first interface passivation layer 14 is located between the substrate 10 and the first doped layer 11. The second interface passivation layer 15 is located between the second doped layer 12 and the first doped layer 11 and between the substrate 10 and the second doped layer 12. The substrate 10 and the first doped layer 11 are respectively performed interface passivation by using the first interface passivation layer 14 and the second interface passivation layer 15, the recombination of the carriers at the interface are reduced, and the transmission efficiency of the carrier is ensured.

In some examples, the first interface passivation layer 14 and the second interface passivation layer 15 may be one or more of oxides, nitrides, carbides, hydrogenated amorphous silicon. Wherein the oxides include one or more of silicon oxide, silicon oxynitride, aluminum oxide, titanium oxide, hafnium oxide (HfO₂), gallium oxide (Ga₂O₃), tantalum pentoxide (Ta₂O₅) and niobium pentoxide (Nb₂O₅) and other substances. Nitrides include one or more of silicon nitride, silicon carbonitride, aluminum nitride, titanium nitride (TiN), titanium carbonitride (TiCN), and the like. Carbides include SiC.

In some examples, when the first doped layer 11 and the second doped layer 12 are semiconductor doped layers, the first interface passivation layer 14 and the second interface passivation layer 15 may be tunneling oxide layers. The tunneling oxide layer allows majority carriers to tunnel into the semiconductor doped layer while blocking the passage of minority carriers. The majority carriers are then laterally transported within the semiconductor doped layer and collected by the electrodes, the recombination of the carriers is reduced and the open circuit voltage and short circuit current of the back contact solar cell are increased. At this moment, a tunneling oxide layer passivation contact structure is constituted by the tunneling oxide layer and the semiconductor doped layer, the selective collection of carriers and the excellent interface passivation may be achieved, and the power conversion efficiency of the back contact solar cell is improved. Both of the first interface passivation layer 14 and the second interface passivation layer 15 may be silicon oxide interface passivation layers. Compared with the amorphous silicon interface passivation layer which is transformed into polycrystalline silicon at a high temperature, the silicon oxide interface passivation layer is more resistant to a high temperature and is not easily denatured.

In some examples, when the first interface passivation layer 14 and the second interface passivation layer 15 are tunneling oxide layers, a thickness of the first interface passivation layer 14 and a thickness of the second interface passivation layer 15 range from 0.5 nm to 5 nm, wherein the thickness of the second interface passivation layer 15 is optionally 1 nm.

In practical applications, the first interface passivation layer 14 may be formed on the substrate 10 before the first doped layer 11 is formed, and removed at the same time as the first doped layer 11 is removed. The second interface passivation layer 15 may be formed on the first doped layer 11 and the second doped region 102 before the second doped layer 12 is formed, and removed at the same time as the second doped layer 12 is removed. In addition, when the first interface passivation layer 14 and the second interface passivation layer 15 are both tunneling oxide layers, the first interface passivation layer 14 and the first doped layer 11 may also be formed in the same process, and the second interface passivation layer 15 and the second doped layer 12 may be formed in the same process. The process of forming the first interface passivation layer 14 and the second interface passivation layer 15 may be a plasma chemical vapor deposition (PECVD) process, an atmospheric vapor deposition (APCVD) process, a thermal growth process, etc. The process of removing the first interface passivation layer 14 and the second interface passivation layer 15 may be a laser etching process, an ion milling etching process, a plasma etching process, a reactive ion etching process, an alkali etching process, an acid etching process, etc.

In some examples, as shown in FIG. 3, when the back contact solar cell has the first interface passivation layer 14 and the second interface passivation layer 15, the second doped layer 12 and the second interface passivation layer 15 may be penetrated by the isolating trench 1030. Still alternatively, as shown in FIG. 4, when the back contact solar cell has the first surface passivation layer 13, the second doped layer 12, the second interface passivation layer 15, the first doped layer 11, and the first interface passivation layer 14 may be penetrated by the isolating trench 1030.

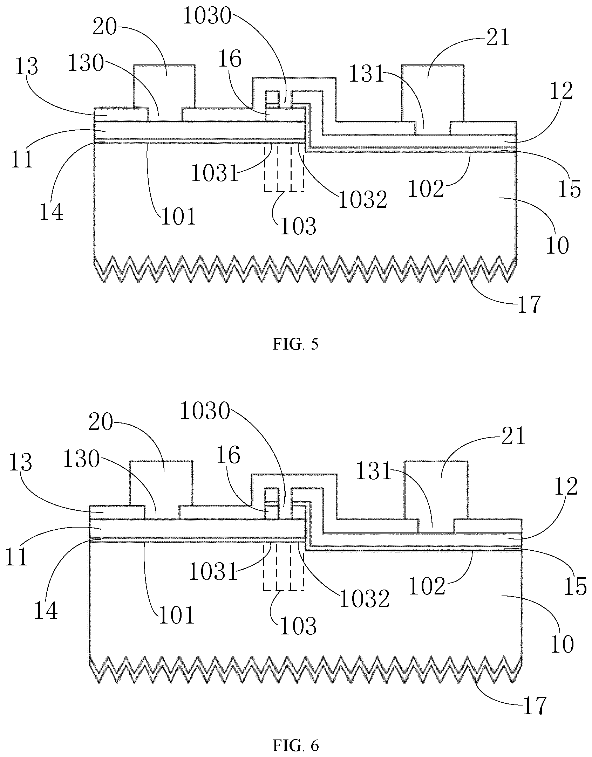

As some possible embodiments, as shown in FIGs. 5-7, the back contact solar cell further includes a first protecting layer 16 located between the first doped layer 11 and the second interface passivation layer 15.

Based on this, the first doped layer 11 and the second doped layer 12 of the overlapping region may be completely separated by the first protecting layer 16, thereby the adverse effect of the second doped layer 12 on the first doped layer 11 in subsequent processes is reduced. For example, in the case where there is no first protecting layer 16, and the first doped layer 11 is directly contacted with the second doped layer 12 or contacted with the second doped layer 12 via the second interface passivation layer 15, when at least one of the first doped layer 11 and the second doped layer 12 is a doped amorphous silicon layer which needs to be transformed into a doped polycrystalline silicon layer by crystallization, since the crystallization time is longer, the second interface passivation layer 15 is thinner, and the conductivity type of the second doped layer 12 and the conductivity type of the first doped layer 11 are opposite. Long-time crystallization may enable the doped element in the second doped layer 12 to enter the first doped layer 11, cause damage to the first doped layer 11, and may even cause the conductivity type of the first doped layer 11 to change, resulting in that the solar cell cannot generate power normally. In addition, in the process of gradually forming a back contact solar cell, the formed first protective layer 16 can protect the lower first doped layer 11 during the subsequent patterning treatment, the surface texturing treatment and the cleaning process, so that the lower first doped layer 11 may not be corroded or damaged.

In some examples, the first protecting layer 16 includes at least one of a dielectric layer and a masking layer. The dielectric layer and/or masking layer used for the first protecting layer 16 differs significantly in physical or chemical properties from the first doped layer 11 to ensure that the first protecting layer 16 is effectively retained when the first doped layer 11 on the second doped region 102 is removed by using an etching process or a corroding process.

In practical applications, the material of the first protecting layer 16 may be one or more of an oxide, a nitride, a carbide and hydrogenated amorphous silicon. The oxide includes one or more of silicon oxide, silicon oxynitride, aluminum oxide, titanium oxide, hafnium oxide (HfO₂), gallium oxide (Ga₂O₃), tantalum pentoxide (Ta₂O₅) and niobium pentoxide (Nb₂O₅) and other substances. The nitride includes one or more of silicon nitride, silicon carbonitride, aluminum nitride, titanium nitride (TiN), titanium carbonitride (TiCN), and the like. The carbide includes SiC.

For example, when the alkaline etching process is used to remove the first doped layer 11 on the second doped region 102, a dielectric layer that does not react with the alkaline used may be selected as the first protecting layer 16. Instead, the first doped layer 11 will react with the alkaline used. Based on this, during the process of patterning the first doped layer 11, the first doped layer 11 located in the second doped region 102 is removed and the first doped layer 11 covered by the first protecting layer 16 remains intact. Exemplarily, a dielectric material such as silicon oxide, silicon nitride, or SiCₓ may be selected as the dielectric layer. When an oxide is selected as the dielectric layer, the dielectric layer may be formed by using the thermal growth process, i.e., by using the heating method under an oxidizing atmosphere (e.g., air, oxygen, etc.), so that the oxide dielectric layer is formed on the surface of the first doped layer 11.

As another example, when the laser etching process is used to remove the first doped layer 11 located in the second doped region 102, a mask layer resistant to laser ablation may be selected as the first protecting layer 16. Instead, the first doped layer 11 may be ablated by the laser. Based on this, during the process of patterning the first doped layer 11, the first doped layer 11 located in the second doped region 102 may be removed and the first doped layer 11 covered by the first protecting layer 16 remains intact. Exemplarily, the mask layer used may be selected from a photolithography-development or laser-patterned mask, a colloidal mask that may be printed, silicon nitride (SiNₓ), silicon oxide (SiOₓ), or silicon carbide (SiC) and the like.

In addition, when the first protecting layer 16 is a stack structure of the dielectric layer and the mask layer, optionally, the dielectric layer should be close to the first doped layer 11 so as to ensure the passivation effect of the first doped layer 11. Since the mask layer has more impurities, it should be far away from the first doped layer 11 to prevent the first doped layer 11 from being contaminated.

In practical applications, the material of the first protecting layer 16 may be silicon oxide. Due to the property of the silicon oxide that the silicon oxide does not react with the alkali, the silicon oxide may better protect the integrity of the first doped layer 11 when the etching is performed using the alkali in a subsequent process. In addition, the silicon oxide has a good interface passivation effect and may passivate the dangling bonds on the surface of the first doped layer 11, inhibit the recombination of carriers on the surface of the first doped layer 11, and thus the power conversion efficiency of the solar cell is improved.

When the first protecting layer 16 is formed, a structure in which only the overlapping region 103 finally has the first protecting layer 16 may be gradually formed. For example, a layer of the first protecting layer 16 covered on the first doped layer 11, the overlapping region 103 and the second doped region 102 may be formed on the patterned first doped layer 11 firstly, and then the first protecting layer 16 located on the second doped region 102 and the first doped region 101 is removed successively, in this way, the protective effect of the first protecting layer 16 may be fully exerted, and the first doped layer 11 and the substrate 10 below the first protecting layer are protected from damage and destruction in subsequent process treatments. In addition, when the second doped layer 12 is formed, after a whole layer of the second doped layer 12 is formed on the first doped layer 11 and the second doped region 102, a patterned second protecting layer may be formed on the second doped layer 12. Then, the second protecting layer and the second doped layer 12 at the first doped region 101 are removed, and the second protecting layer is removed. The patterned second protecting layer may protect the second doped layer 12 at the second region and the overlapping region 103 as the second protecting layer and the second doped layer 12 at the first doped region 101 are removed. The formation process, removal and patterning process, material selection, etc. of the second protecting layer are the same as those of the first protecting layer 16. Optionally, the process of patterning the second protecting layer is laser etching. Optionally, the second protecting layer is a mask layer, and may be selected from the material such as silicon nitride (SiNₓ), silicon oxide (SiOₓ), or silicon carbide (SiC).

In practical applications, when the first protecting layer 16 and the second protecting layer include a silicon oxide layer, the silicon oxide layer may be formed at the same time as the first doped layer 11 or the second doped layer 12 is formed. Taking the first protecting layer 16 as an example, when the first protecting layer 16 is silicon oxide and the first doped layer 11 is a boron-doped p-type polycrystalline silicon layer, after an intrinsic polycrystalline silicon layer is formed, a thermal diffusion process may be used to dope the intrinsic polycrystalline silicon layer by introducing a gas such as BCl₃ or BBr₃ in a heating state (oxygen may be introduced during the thermal diffusion process) so as to form a p-type polycrystalline silicon layer. At a same time, a layer of silicon oxide may be formed on the surface of the p-type polycrystalline silicon layer. When the substrate 10 is a p-type silicon substrate 10, a phosphorus-doped thermal diffusion process may be used. At this moment, the in-situ doped p-type polysilicon layer may be replaced with an n-type polysilicon layer. The POCl₃ used for thermal diffusion may likewise form a phosphorus doped n-type polysilicon layer and silicon oxide on the phosphorus doped n-type polysilicon layer.

In some examples, as shown in FIG. 5, when the back contact solar cell has a first protecting layer 16, a first interface passivation layer 14 and a second interface passivation layer 15 at the same time, the second doped layer 12 and the second interface passivation layer 15 may be penetrated by the isolating trench 1030. Alternatively, as shown in FIG. 6, the second doped layer 12, the second interface passivation layer 15 and the first protecting layer 16 may be penetrated by the isolating trench 1030. Still alternatively, as shown in FIG. 7, the second doped layer 12, the second interface passivation layer 15, the first protecting layer 16, the first doped layer 11, and the first interface passivation layer 14 may be penetrated by the isolating trenchs 1030. Optionally, the isolating trench has a structure as shown in FIGs. 6 and 7. In practical applications, a step of cleaning with a hydrofluoric acid (HF)-containing solution is performed before the first surface passivation layer is formed, and a common structure is formed as shown in FIG. 6. When the isolating trench is formed in the final process, a common structure formed is a structure as shown in FIG. 7.

As some possible embodiments, as shown in FIGs. 1-7, the second surface has a textured structure. There is also a second surface passivation layer 17 on the second surface. The textured structure of the second surface has a good light trapping effect, the reflection of light incident on the second surface may be reduced and the utilization rate of light is improved. The second surface passivation layer 17 provides a function of passivating the interface of the substrate 10 for the second surface, the recombination of carriers at the interface is reduced, the transport efficiency of the carriers is improved, and thus the power conversion efficiency of the back contact solar cell is improved. In practical applications, the overlapping region 103 may be trenched while texturing the second surface so that the second surface has a textured structure. The second surface passivation layer 17 may be formed on the textured structure of the second surface at the same time as the first surface passivation layer 13 is formed. The material selection and the preparation process of the second surface passivation layer 17 are the same as the material selection and the preparation process of the first surface passivation layer 13.

In some examples, the material of the second surface passivation layer 17 may be one or more of silicon nitride, silicon oxide, silicon oxynitride, aluminum oxide, silicon carbide, and amorphous silicon.

As one possible embodiment, as shown in FIGs. 2, 4, and 7, when the isolating trench 1030 is an isolating trench 1030 penetrating the substrate 10, the bottom of the isolating trench 1030 may also have a textured structure. At this moment, there is not an electrode disposed on the isolating trench 1030, and the isolating trench 1030 may be textured so that the isolating trench 1030 has a textured structure. Since the textured structure has a good light trapping effect and anti-reflection effect, the light incident on the first surface may also be used, the light absorption effect of the back contact solar cell on the first surface is increased, the back contact solar cell may absorb light energy at both sides, further use of light energy is achieved, and the power generation efficiency of the back contact solar cell is improved.

As some possible embodiments, the second surface of the back contact solar cell further includes an anti-reflection layer. The anti-reflection layer may be formed on the second surface passivation layer 17. The anti-reflection layer may reduce reflection of light incident on the second surface, improve the refraction of the light, increase the utilization ratio of the light incident on the second surface, thereby power conversion efficiency of the back contact solar cell is improved.

In some examples, the first surface passivation layer 13 and the second surface passivation layer 17 also have an anti-reflection effect. It is also possible to laminate the passivation layer and the anti-reflection layer so as to play a role in the anti-reflection as a whole.

In some examples, the anti-reflection layer may be one or more of magnesium fluoride (MgF₂), silicon dioxide (SiO₂), aluminum oxide (Al₂O₃), zinc sulfide (ZnS), silicon nitride (SiN), titanium dioxide (TiO₂), and the like.

Exemplarily, the anti-reflection layer may be an aluminum oxide anti-reflection layer, and may also be an anti-reflection layer included of a stack of silicon nitride and silicon oxide.

In the above description of embodiments, the particular features, structures, materials, or characteristics described may be combined in any suitable manner in any one or more embodiments or instances.

The above are merely particular embodiments of the present disclosure, but the protection scope of the present disclosure is not limited thereto. All of the variations or substitutions that a person skilled in the art can easily envisage within the technical scope disclosed by the present disclosure should fall within the protection scope of the present disclosure. Therefore, the protection scope of the present disclosure should be subject to the protection scope of the claims.

## Claims

1. A back contact solar cell, comprising:
a substrate (10), wherein the substrate (10) has a first surface and a second surface opposite to each other, there are a first doped region (101), a second doped region (102) and an overlapping region (103) on the first surface, the first doped region (101) and the second doped region (102) are arranged in a staggered manner, and the overlapping region (103) is located between the first doped region (101) and the second doped region (102); the overlapping region (103) has an isolating trench (1030) for insulating contact between the first doped region (101) and the second doped region (102);
a first doped layer (11) formed on the first doped region (101) and the overlapping region (103);
a first interface passivation layer (14), located between the substrate (10) and the first doped layer (11);
a second doped layer (12) formed on the first doped layer (11) on the overlapping region (103) and the second doped region (102), wherein a conductivity type of the second doped layer (12) is opposite to a conductivity type of the first doped layer (11); and
a second interface passivation layer (15), located between the second doped layer (12) and the first doped layer (11) and between the substrate (10) and the second doped layer (12);
wherein the second doped layer (12) on the overlapping region (103) is penetrated by the isolating trench (1030); the overlapping region (103) is divided by the isolating trench (1030) into a first overlapping region (1031) and a second overlapping region (1032); the first overlapping region (1031) is close to the first doped region (101), and the second overlapping region (1032) is close to the second doped region (102); and
the back contact solar cell further comprises a first electrode (20) and a second electrode (21), wherein the first electrode (20) is electrically contacted with the first doped layer (11) and the second electrode (21) is electrically contacted with the second doped layer (12), **characterized in that**:
the back contact solar cell further comprises a first surface passivation layer (13) coated on the first doped layer (11), the second doped layer (12) and the overlapping region (103); wherein the isolating trench (1030) is filled by the first surface passivation layer (13); and
a contact surface between the first surface passivation layer (13) and the first doped layer (11) is provided with a first opening (130), and the first electrode (20) is electrically contacted with the first doped layer (11) via the first opening (130); and a contact surface between the first surface passivation layer (13) and the second doped layer (12) is provided with a second opening (131), and the second electrode (21) is electrically contacted with the second doped layer (12) via the second opening (131).

2. The back contact solar cell according to claim 1, wherein the second doped layer (12) and the first doped layer (11) on the overlapping region (103) are penetrated by the isolating trench (1030).

3. The back contact solar cell according to claim 1 or claim 2, wherein a ratio of a width of the first overlapping region (1031) to a width of the first doped region (101) ranges from 0.1 to 5.

4. The back contact solar cell according to claim 1 or claim 2, wherein a ratio of a width of the second overlapping region (1032) to a width of the second doped region (102) is greater than 0 and less than or equal to 0.1.

5. The back contact solar cell according to claim 1 or claim 2, wherein a surface of the first doped region (101) and/or a surface of the second doped region (102) is a polished surface.

6. The back contact solar cell according to claim 1 or claim 2, wherein the substrate (10) is an n-type substrate (10); the first doped layer (11) is a p-type doped layer; and the second doped layer (12) is the n-type doped layer; or
the substrate (10) is the p-type substrate (10); the first doped layer (11) is the n-type doped layer; and the second doped layer (12) is the p-type doped layer.

7. The back contact solar cell according to claim 1, wherein the back contact solar cell further comprises a first protecting layer (16) located between the first doped layer (11) and the second interface passivation layer (15).

8. The back contact solar cell according to claim 7, wherein the second doped layer (12) and the second interface passivation layer (15) are penetrated by the isolating trench (1030); or
the second doped layer (12), the second interface passivation layer (15) and the first protecting layer (16) are penetrated by the isolating trench (1030); or
the second doped layer (12), the second interface passivation layer (15), the first protecting layer (16), the first doped layer (11) and the first interface passivation layer (14) are penetrated by the isolating trench (1030).

## Patentansprüche

1. Rückkontakt-Solarzelle, umfassend:
ein Substrat (10), wobei das Substrat (10) eine erste Oberfläche und eine zweite Oberfläche entgegengesetzt zueinander aufweist, wobei eine erste dotierte Region (101), eine zweite dotierte Region (102) und eine Überlappungsregion (103) auf der ersten Oberfläche vorliegen, wobei die erste dotierte Region (101) und die zweite dotierte Region (102) auf gestaffelte Weise eingerichtet sind und sich die Überlappungsregion (103) zwischen der ersten dotierten Region (101) und der zweiten dotierten Region (102) befindet; wobei die Überlappungsregion (103) einen Isoliergraben (1030) zum Isolieren eines Kontakts zwischen der ersten dotierten Region (101) und der zweiten dotierten Region (102) aufweist;
eine erste dotierte Schicht (11), die auf der ersten dotierten Region (101) und der Überlappungsregion (103) ausgebildet ist;
eine erste Grenzflächenpassivierschicht (14), die sich zwischen dem Substrat (10) und der ersten dotierten Schicht (11) befindet;
eine zweite dotierte Schicht (12), die auf der ersten dotierten Schicht (11) auf der Überlappungsregion (103) und der zweiten dotierten Schicht (102) ausgebildet ist, wobei ein Leitfähigkeitstyp der zweiten dotierten Schicht (12) entgegengesetzt zu einem Leitfähigkeitstyp der ersten dotierten Schicht (11) ist; und
eine zweite Grenzflächenpassivierschicht (15), die sich zwischen der zweiten dotierten Schicht (12) und der ersten dotierten Schicht (11) und zwischen dem Substrat (10) und der zweiten dotierten Schicht (12) befindet;
wobei die zweite dotierte Schicht (12) auf der Überlappungsregion (103) von dem Isoliergraben (1030) durchdrungen wird; die Überlappungsregion (103) von dem Isoliergraben (1030) in eine erste Überlappungsregion (1031) und eine zweite Überlappungsregion (1032) aufgeteilt wird; die erste Überlappungsregion (1031) nahe der ersten dotierten Region ist (101) und die zweite Überlappungsregion (1032) nahe der zweiten dotierten Region (102) ist; und
die Rückkontakt-Solarzelle ferner eine erste Elektrode (20) und eine zweite Elektrode (21) umfasst, wobei die erste Elektrode (20) mit der ersten dotierten Schicht (11) in elektrischen Kontakt gebracht wird und die zweite Elektrode (21) mit der zweiten dotierten Schicht (12) in elektrischen Kontakt gebracht wird, **dadurch gekennzeichnet, dass**:
die Rückkontakt-Solarzelle ferner eine erste Oberflächenpassivierschicht (13) umfasst, die auf die erste dotierte Schicht (11), die zweite dotierte Schicht (12) und die Überlappungsregion (103) beschichtet ist; wobei der Isoliergraben (1030) durch die erste Oberflächenpassivierschicht (13) gefüllt ist; und
eine Kontaktoberfläche zwischen der ersten Oberflächenpassivierschicht (13) und der ersten dotierten Schicht (11) mit einer ersten Öffnung (130) versehen ist und die erste Elektrode (20) mittels der ersten Öffnung (130) mit der ersten dotierten Schicht (11) in elektrischen Kontakt gebracht wird; und eine Kontaktoberfläche zwischen der ersten Oberflächenpassivierschicht (13) und der zweiten dotierten Schicht (12) mit einer zweiten Öffnung (131) versehen ist und die zweite Elektrode (21) mittels der zweiten Öffnung (131) mit der zweiten dotierten Schicht (12) in elektrischen Kontakt gebracht wird.

2. Rückkontakt-Solarzelle nach Anspruch 1, wobei die zweite dotierte Schicht (12) und die erste dotierte Schicht (11) auf der Überlappungsregion (103) von dem Isoliergraben (1030) durchdrungen werden.

3. Rückkontakt-Solarzelle nach Anspruch 1 oder Anspruch 2, wobei ein Verhältnis einer Breite der ersten Überlappungsregion (1031) zu einer Breite der ersten dotierten Region (101) von 0,1 bis 5 reicht.

4. Rückkontakt-Solarzelle nach Anspruch 1 oder Anspruch 2, wobei ein Verhältnis einer Breite der zweiten Überlappungsregion (1032) zu einer Breite der zweiten dotierten Region (102) größer als 0 und kleiner als oder gleich 0,1 ist.

5. Rückkontakt-Solarzelle nach Anspruch 1 oder Anspruch 2, wobei eine Oberfläche der ersten dotierten Region (101) und/oder eine Oberfläche der zweiten dotierten Region (102) eine polierte Oberfläche ist.

6. Rückkontakt-Solarzelle nach Anspruch 1 oder Anspruch 2, wobei das Substrat (10) ein Substrat vom n-Typ (10) ist; die erste dotierte Schicht (11) eine dotierte Schicht vom p-Typ ist und die zweite dotierte Schicht (12) die dotierte Schicht vom n-Typ ist; oder
das Substrat (10) ein Substrat vom p-Typ (10) ist; die erste dotierte Schicht (11) die dotierte Schicht vom n-Typ ist und die zweite dotierte Schicht (12) die dotierte Schicht vom p-Typ ist.

7. Rückkontakt-Solarzelle nach Anspruch 1, wobei die Rückkontakt-Solarzelle ferner eine erste Schutzschicht (16) umfasst, die sich zwischen der ersten dotierten Schicht (11) und der zweiten Grenzflächenpassivierschicht (15) befindet.

8. Rückkontakt-Solarzelle nach Anspruch 7, wobei die zweite dotierte Schicht (12) und die zweite Grenzflächenpassivierschicht (15) von dem Isoliergraben (1030) durchdrungen werden; oder
die zweite dotierte Schicht (12), die zweite Grenzflächenpassivierschicht (15) und die erste Schutzschicht (16) von dem Isoliergraben (1030) durchdrungen werden; oder
die zweite dotierte Schicht (12), die zweite Grenzflächenpassivierschicht (15). die erste Schutzschicht (16), die erste dotierte Schicht (11) und die erste Grenzflächenpassivierschicht (14) von dem Isoliergraben (1030) durchdrungen werden.

## Revendications

1. Cellule solaire à contact arrière, comprenant:
un substrat (10), dans lequel le substrat (10) comporte une première surface et une deuxième surface opposées l'une à l'autre, il existe une première région dopée (101), une deuxième région dopée (102) et une région de chevauchement (103) sur la première surface, la première région dopée (101) et la deuxième région dopée (102) sont disposées en quinconce, et la région de chevauchement (103) est située entre la première région dopée (101) et la deuxième région dopée (102); la région de chevauchement (103) comporte une tranchée d'isolation (1030) pour isoler le contact entre la première région dopée (101) et la deuxième région dopée (102);
une première couche dopée (11) formée sur la première région dopée (101) et la région de chevauchement (103);
une première couche de passivation d'interface (14), située entre le substrat (10) et la première couche dopée (11);
une deuxième couche dopée (12) formée sur la première couche dopée (11) sur la région de chevauchement (103) et la deuxième région dopée (102), dans laquelle un type de conductivité de la deuxième couche dopée (12) est opposé à un type de conductivité de la première couche dopée (11); et
une deuxième couche de passivation d'interface (15), située entre la deuxième couche dopée (12) et la première couche dopée (11) et entre le substrat (10) et la deuxième couche dopée (12);
dans laquelle la deuxième couche dopée (12) sur la région de chevauchement (103) est traversée par la tranchée d'isolation (1030); la région de chevauchement (103) est divisée par la tranchée d'isolation (1030) en une première région de chevauchement (1031) et une deuxième région de chevauchement (1032); la première région de chevauchement (1031) est proche de la première région dopée (101), et la deuxième région de chevauchement (1032) est proche de la deuxième région dopée (102); et
la cellule solaire à contact arrière comprend de plus une première électrode (20) et une deuxième électrode (21), dans laquelle la première électrode (20) est en contact électrique avec la première couche dopée (11) et la deuxième électrode (21) est en contact électrique avec la deuxième couche dopée (12), **caractérisée en ce que**:
la cellule solaire à contact arrière comprend en outre une première couche de passivation de surface (13) appliquée sur la première couche dopée (11), la deuxième couche dopée (12) et la région de chevauchement (103); dans laquelle la tranchée d'isolation (1030) est remplie par la première couche de passivation de surface (13); et
une surface de contact entre la première couche de passivation de surface (13) et la première couche dopée (11) est pourvue d'une première ouverture (130), et la première électrode (20) est en contact électrique avec la première couche dopée (11) via la première ouverture (130); et une surface de contact entre la première couche de passivation de surface (13) et la deuxième couche dopée (12) est pourvue d'une deuxième ouverture (131), et la deuxième électrode (21) est en contact électrique avec la deuxième couche dopée (12) via la deuxième ouverture (131).

2. Cellule solaire à contact arrière selon la revendication 1, dans laquelle la deuxième couche dopée (12) et la première couche dopée (11) sur la région de chevauchement (103) sont traversées par la tranchée d'isolation (1030).

3. Cellule solaire à contact arrière selon la revendication 1 ou la revendication 2, dans laquelle un rapport entre une largeur de la première région de chevauchement (1031) et une largeur de la première région dopée (101) est compris entre 0,1 et 5.

4. Cellule solaire à contact arrière selon la revendication 1 ou la revendication 2, dans laquelle un rapport entre une largeur de la deuxième région de chevauchement (1032) et une largeur de la deuxième région dopée (102) est supérieur à 0 et inférieur ou égal à 0,1.

5. Cellule solaire à contact arrière selon la revendication 1 ou la revendication 2, dans laquelle une surface de la première région dopée (101) et/ou une surface de la deuxième région dopée (102) est une surface polie.

6. Cellule solaire à contact arrière selon la revendication 1 ou la revendication 2, dans laquelle le substrat (10) est un substrat de type n (10); la première couche dopée (11) est une couche dopée de type p; et la deuxième couche dopée (12) est la couche dopée de type n; ou
le substrat (10) est le substrat de type p (10); la première couche dopée (11) est la couche dopée de type n; et la deuxième couche dopée (12) est la couche dopée de type p.

7. Cellule solaire à contact arrière selon la revendication 1, dans laquelle la cellule solaire à contact arrière comprend en outre une première couche de protection (16) située entre la première couche dopée (11) et la deuxième couche de passivation d'interface (15).

8. Cellule solaire à contact arrière selon la revendication 7, dans laquelle la deuxième couche dopée (12) et la deuxième couche de passivation d'interface (15) sont traversées par la tranchée d'isolation (1030); ou
la deuxième couche dopée (12), la deuxième couche de passivation d'interface (15) et la première couche de protection (16) sont traversées par la tranchée d'isolation (1030); ou
la deuxième couche dopée (12), la deuxième couche de passivation d'interface (15), la première couche de protection (16), la première couche dopée (11) et la première couche de passivation d'interface (14) sont traversées par la tranchée d'isolation (1030).
